# EUROPEAN PATENT SPECIFICATION

(11) **EP 2 199 035 B1**
(45) Date of publication and mention of the grant of the patent: **01.08.2012**
(21) Application number: 08831053.7
(22) Date of filing: 29.08.2008
(51) Int. Cl.: B25J 9/06, B65G 49/06, H01L 21/677

(54) **TRANSFER ROBOT**
TRANSFERROBOTER
ROBOT DE TRANSFERT

(30) Priority: 13.09.2007 JP 2007237500; 19.11.2007 JP 2007299120
(43) Date of publication of application: 23.06.2010
(73) Proprietor: Kabushiki Kaisha Yaskawa Denki, Kitakyushu-shi, Fukuoka 806-0004 (JP)
(72) Inventor: SUEYOSHI, Satoshi, Fukuoka 8006-0004 (JP); TANAKA, Kentaro, Fukuoka 8006-0004 (JP); MATSUO, Tomohiro, Fukuoka 8006-0004 (JP)
(74) Representative: Gendron, Vincent Christian
(86) International application number: PCT/JP2008/065491
(87) International publication number: WO 2009/034854

(56) References cited:
- JP-A- 7 050 334
- JP-A- 06 338 555
- JP-A- 07 050 334
- JP-A- 09 162 257
- JP-A- 11 188 669
- JP-A- 2000 243 809
- JP-A- 2001 274 218
- JP-A- 2003 275 980
- JP-A- 2004 106 167
- JP-A- 2005 150 575
- JP-A- 2006 176 276
- JP-A- 2006 176 276

## Description

### Technical Field

The present invention relates to a transfer robot that moves thin plate-shaped workpieces, such as glass substrates for liquid crystal displays and semiconductor wafers, in and out of a cabinet. The present invention more specifically relates to a transfer robot according to the preamble of claim 1. Such robot is known from the document JP-A-06338555.

### Background Art

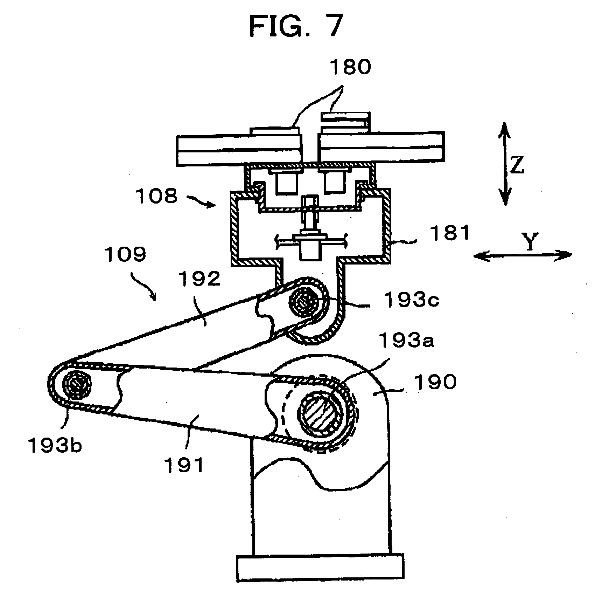

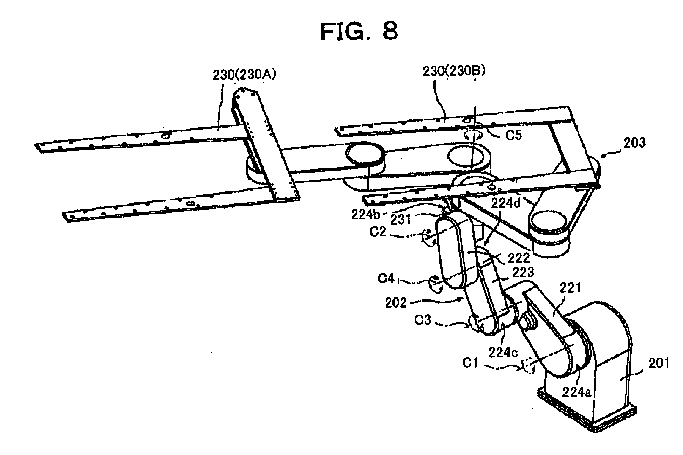

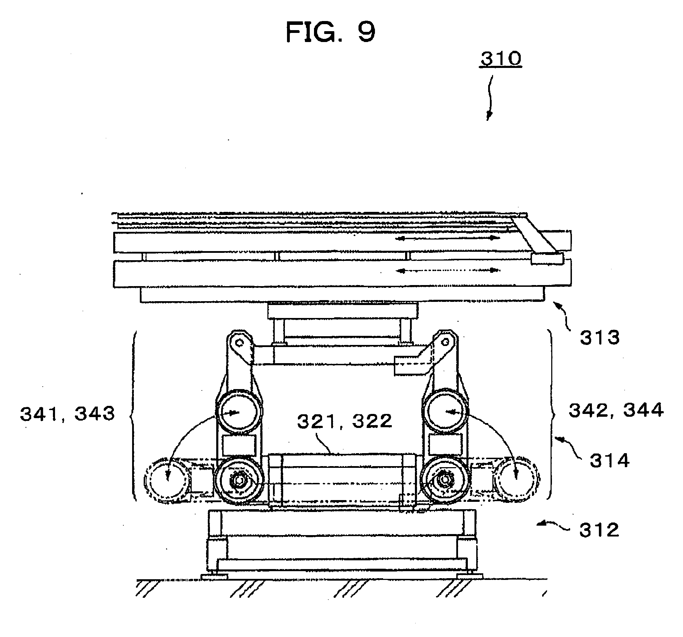

Some existing transfer robots that have been proposed move up and down by extending and contracting their legs and transfer a workpiece by using an arm disposed in an upper part of the robots (for example, see Patent Documents 1 to 3).
As illustrated in Fig. 7, a first existing transfer robot includes a hand member actuator 108 and a link mechanism 109. The hand member actuator 108 moves a hand member 180 in horizontal directions perpendicular to the paper surface (the X directions, not shown by a symbol in the figure). The link mechanism 109 moves the entirety of the hand member actuator 108. The link mechanism 109 includes a first arm section 191 and a second arm section 192. A first end of the first arm section 191 is rotatably connected to a base member 190 via a connection section 193a. The second arm section 192 is connected to a second end of the first arm section 191 via a connection section 193b. A second end of the second arm section 192 is rotatably connected to a base section 181 of the hand member actuator 108 via a connection section 193c.
The first existing transfer robot rotates the first and second arm sections 191 and 192 so as to linearly move a workpiece in the Y directions (the directions perpendicular to the paper surface of Fig. 7) and in the Z directions. However, the movement range is comparatively narrow, although in some cases it is required for the robot to be capable of linearly moving the hand member in as large a region as possible in horizontal and vertical directions.
To address this problem, a second existing example was proposed. Referring to Fig. 8, the second existing example will be described. The second existing example includes a base member 201, a link mechanism 202, and a hand member actuator 203 including two hand members 230 (230A and 230B). The base member 201 has a box-like shape with a certain height, and, for example, is fixed to a floor. However, the base member 201 may be made to be movable in the Y directions as described below. The link mechanism 202 includes first and second arm sections 221 and 222 and a middle arm section 223 that are connected to each other via first to fourth connection sections 224a to 224d. The first to fourth connection sections 224a to 224d respectively have axes C1 to C4 that extend in the same direction. A first end of the first arm section 221 is connected to an upper side of the base member 201 via the first connection section 224a, so that the first arm section 221 can rotate around the axis C1. The distance from the axis C1 to a second end of the first arm section 221 is smaller than the distance from the floor to the axis C1. Thus, the first arm section 221 can rotate by 360 degrees around the axis C1. The middle arm section 223 has a length that is substantially the same as that of the first arm section 221. A first end of the middle arm section 223 is connected to a second end of the first arm section 221 via the third connection section 224c, so that the middle arm section 223 can rotate relative to the first arm section 221 around the axis C3. The second arm section 222 has a length that is smaller than those of the first arm section 221 and the middle arm section 223. A first end of the second arm section 222 is connected to the second end of the middle arm section 223 via the fourth connection section 224d, so that the second arm section 222 can rotate relative to the middle arm section 223 around the axis C4. A second end of the second arm section 222 is connected to a base section 231 of the hand member actuator 203 via the second connection section 224b. Thus, the hand member actuator 203 can rotate relative to the second arm section 222 around the axis C2.
Referring to Fig. 9, a third existing example will be described. In the third existing example, a lift apparatus 310 includes a base unit 312 including a plurality of posts 321 and 322, a workpiece supporting unit 313 for supporting a workpiece, and a lift mechanism 314. The lift mechanism 314 includes a plurality of arm units 341, 342, 343, and 344. First ends of the arm units are connected to the posts 321 and 322 of the base unit 312 and second ends of the arm units are connected to the workpiece supporting unit 313, so that a lift mechanism 314 can extend and contract. When a workpiece is moved upward, the workpiece supporting unit 313 becomes disposed at a position higher than those of the posts 321 and 322. When the workpiece is moved downward, at least a part of the workpiece supporting unit 313 becomes disposed between the posts 321 and 322.
[Patent Document 1] Japanese Unexamined Patent Application Publication No. 11-238779 (page 4, Fig. 2)
[Patent Document 2] Japanese Unexamined Patent Application Publication No. 2002-210684 (page 6, Fig. 2)
[Patent Document 3] Japanese Unexamined Patent Application Publication No. 2006-176276 (page 4, Fig. 1)

### Disclosure of the Invention

### Problems to be Solved by the Invention

A cabinet stores thin plate-shaped workpieces, such as glass substrates for liquid crystal displays or solar panels, which are stacked with gaps therebetween from a height near the floor to a height near the ceiling. Cabinets of this type are disposed to the front, back, left, or right of a transfer robot. Therefore, the transfer robot has to have a large size, and has to include a long-stroke lift mechanism and a rotation mechanism. As the size of such a transfer robot has become larger, an increasing number of cabinets have been disposed at an angle toward a roll direction with respect to the direction in which the transfer robot takes out a workpiece. In this case, when the transfer robot receives a workpiece with its hand, the position of the workpiece may be displaced because the hand is at an angle relative to the cabinet, so that the workpiece may not be placed at a predetermined position at a destination. Therefore, a correction function with respect to the roll direction is necessary. Moreover, the workpiece may not be placed at a correct position in the cabinet. For example, the workpiece may be placed at an angle in a yaw direction or laterally displaced with respect to the direction in which the transfer robot takes out the workpiece. The correction function for placing the workpiece at a predetermined position at a destination has become necessary. To date, a correction mechanism, which is independent of the transfer robot, has been used for the correction. However, there is a problem in that the system becomes complex and the installation area increases.
Moreover, as workpieces stored in a cabinet become larger and heavier, the transfer robot that transfers such workpieces has to have a high rigidity. In case the lift mechanism breaks down and thereby a workpiece is dropped and damaged, the transfer robot is required to have safety measures to prevent such a situation. Even for large substrates, a higher throughput is required as the production of such substrates increases year by year.
In addition, a system that transports such workpieces requires a clean environment, and the footprint of the transfer robot has to be to be small even it the size of the transfer robot is large.
Although the first existing transfer robot can linearly move a workpiece in horizontal and vertical directions by rotating the first and second arm sections, the range of vertical movement is narrow because the hand and the base member interfere with each other and thereby the hand cannot be moved lower than the base member. Moreover, displacement of the workpiece in the cabinet cannot be corrected because the first existing transfer robot does not have a correction mechanism. It is difficult to provide the correction mechanism to the first existing transfer robot because the correction mechanism makes the structure larger and more complex.
The second existing transfer robot has three links so as to increase the range of motion. However, if a drive mechanism of the links breaks down, an expensive workpiece may be damaged because the second existing transfer robot does not have a mechanism for preventing the workpiece from falling.
The footprint of the robot cannot be reduced because the link mechanism is outwardly bent relative to the base member and a large installation space is required when the link mechanism is at a lowered position. The range of movement in the vertical direction is narrow because the hand and the base member interfere with each other and the hand cannot physically be moved lower than the base member at the lowest position.
Lateral displacement of a workpiece in the cabinet may be corrected by moving the workpiece in the horizontal direction while keeping the position of the workpiece in the vertical direction. However, the second existing transfer robot cannot correct the lateral displacement because the robot does not have a sensor required for the correction. Moreover, correction in a roll direction and a yaw direction cannot be made, so that the workpiece cannot be transferred to a predetermined position.
The third existing robot includes four link mechanisms so as to be capable of supporting and moving the workpiece transfer unit up and down. Therefore, if any one of the drive mechanisms of the link mechanisms breaks down, the workpiece can be prevented from falling and can possibly be transferred to a safe position. However, the third existing transfer robot has a problem in that the robot requires a large installation space and a footprint in a lowered position because the link mechanisms are bent outward. The third existing transfer robot can be inclined in a pitch direction with respect to the direction in which the workpiece is taken out. However, the third existing transfer robot has a problem in that the robot cannot place a workpiece at a predetermined position because the robot does not include a correction mechanism for correcting displacements in the roll direction, the yaw direction, and the lateral directions.
It is an object of the present invention to provide a transfer robot that can be disposed in a comparatively small installation space, that has a wide range of up and down motion, that can safely transfer a workpiece, and that can correct angles so as to transfer a workpiece to a predetermined position.
Accordingly, the present invention provides a transfer robot as defined in claim 1.

### Advantages

According to the invention, the lift mechanism includes at least two link mechanisms, the link mechanisms rotate between leg supporting members so as to move the horizontal arm mechanism up and down, and the horizontal arm mechanism is disposed between the leg supporting members when the horizontal arm mechanism is at the lowest position. Therefore, the range of motion in the vertical direction is increased. Because the lift mechanism includes at least two link mechanisms, even if one link mechanism breaks down and cannot generate a driving force, the other link mechanism can generate a driving force. Therefore, a double safety mechanism is provided in that the horizontal arm mechanism is prevented from falling and the workpiece is prevented from being damaged. The horizontal arm mechanism is disposed between the leg supporting members, and the link mechanisms rotate in such a manner that the link mechanisms do not substantially protrude from the outer periphery of the leg supporting members when moving the horizontal arm mechanism to the lowest position. Therefore, because the link mechanisms are bent so that the link mechanism do not substantially protrude to the outside, the transfer robot can be disposed in a comparatively small space and the footprint can be reduced.
The first horizontal joint coaxially disposed with respect to the direction in which the hand is moved, and the hand is moved with an arm that extends and contracts along one direction. Therefore, a workpiece can be rapidly moved in and out of the cabinet by using two hands. Thus, throughput is improved.
The lift mechanism includes two sets of link mechanisms including at least two rotary joints, so that the horizontal arm mechanism can be moved in one of the roll direction and the left-right direction with respect to the direction in which the hand is moved, whereby relative positional displacement between the transfer robot and the cabinet can be corrected by movement of the transfer robot. Therefore, a correction mechanism used in an existing transfer robot is not necessary, so that the transfer robot does not have a complicated structure and can be disposed in a small installation space.
The lift mechanism includes two sets of link mechanisms including at least two rotary joints, and, by using the rotation axis of the transfer robot, displacement of an object placed on the hand can be corrected by moving the horizontal arm mechanism in the roll direction, the yaw direction, and the lateral direction with respect to the direction in which the hand is moved. Therefore, irrespective of the position of the object in the cabinet, the object can be transferred to a predetermined position at a destination.

### Brief Description of Drawings

Fig. 1 is a perspective view of a transfer robot according to an embodiment of the present invention;
Fig. 2 is a perspective view illustrating a state in which a horizontal arm mechanism of the embodiment of the present invention is at the highest position;
Fig. 3 is a perspective view illustrating a state in which the horizontal arm mechanism of the embodiment of the present invention is at the lowest position;
Fig. 4 is a schematic view illustrating movement of a lift mechanism for correcting displacement in the roll direction according to the present invention;
Fig. 5 is a schematic view illustrating movement of a lift mechanism for correcting displacement in the lateral direction according to the present invention;
Fig. 6 is a flowchart illustrating a process of correcting displacement of a workpiece placed on a hand;
Fig. 7 is a front view of a first existing transfer robot;
Fig. 8 is a front view of a second existing transfer robot; and
Fig. 9 is a front view of a third existing transfer robot.

### Reference Numerals

1 mounting base
2 base
3a, 3b leg supporting member
4a, 4b first joint
5a, 5b first leg section
6a, 6b second joint
7a, 7b second leg section
8 supporting base
9a, 9b first horizontal joint
10a, 10b first arm section
11a, 11b second horizontal joint
12a, 12b second arm section
13a, 13b third horizontal joint
14a, 14b hand
15 supporting column
16 supporting member
17 rotation mechanism
20 lift mechanism
30 horizontal arm mechanism
108 hand member actuator
109 link mechanism
180 hand member
181 base section
190 base member
191 first arm section
192 second arm section
193a, 193b, 193c connection section
201 base member
202 link mechanism
203 hand member actuator
221 first arm section
222 second arm section
223 middle arm section
224a first connection section
224b second connection section
224c third connection section
224d fourth connection section
230, 230A, 230B hand member
231 base section
C1, C2, C3, C4, C5 axis
310 lift apparatus
312 base unit
313 workpiece supporting unit
314 lift mechanism
321, 322 post
341, 342, 343, 344 arm unit

### Best Mode for Carrying Out the Invention

Hereinafter, an embodiment of the present invention will be described with reference to the drawings.

### First Embodiment

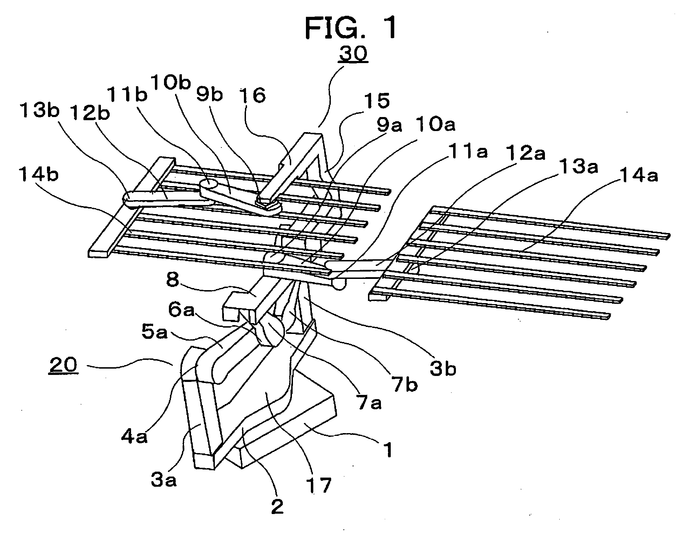

Fig. 1 is a perspective view of a transfer robot according to the present invention.
The transfer robot according to the present invention includes a rotation mechanism 17, a lift mechanism 20, and a horizontal arm mechanism 30 so as to be capable of taking out a workpiece disposed in a cabinet (not shown) and transferring the workpiece to a work area.
The rotation mechanism 17 is disposed in such a manner that the rotation axis of the rotation mechanism 17 is disposed at substantially the center of a base 2 that is attached to a mounting base 1. Leg supporting members 3a and 3b are disposed at ends of the base 2.

In the lift mechanism 20, the leg supporting members 3a and 3b include drive units (not shown) that drive first joints 4a and 4b. First ends of first leg sections 5a and 5b are connected to the first joints 4a and 4b. Second ends of the first leg sections 5a and 5b are connected to first ends of second leg sections 7a and 7b via second joints 6a and 6b that include drive units (not shown). Second ends of the second leg sections 7a and 7b are rotatably connected to a supporting base 8. The first leg sections 5a and 5b have a length greater than that of the leg supporting members 3a and 3b so as to be capable of reducing the height of the horizontal arm mechanism 30 when the horizontal arm mechanism 30 is at the lowest position. The second leg sections 7a and 7b have a length smaller than that of the first leg sections 5a and 5b so that lateral sides of the first leg sections 5a and 5b do not protrude from lateral sides of the leg supporting members 3a and 3b when the horizontal arm mechanism 30 is at the lowest position.
In the present embodiment, both the first joint and the second joint include drive units. However, the second joint may be driven by a drive unit for driving the first joint through a belt drive.

Next, the horizontal arm mechanism 30 will be described. The horizontal arm mechanism 30 includes a double-link mechanism that moves two hands 14a and 14b so as to move a workpiece (not shown) in and out of a cabinet. The hands 14a and 14b are moved in vertical directions in which the horizontal arm mechanism 30 is moved up and down by the lift mechanism 20. The hands 14a and 14b are also moved in directions perpendicular to the direction in which second horizontal joints extend when the hands 14a and 14b are retracted toward the lift mechanism 20. The hands 14a and 14b are linearly moved along one direction.
Details of the horizontal arm mechanism 30 will be described. A first end of a first arm section 10a is connected to a first horizontal joint 9a that is disposed on the supporting base 8 and that includes a drive mechanism (not shown). A second end of the first arm section 10a is connected to a first end of a second arm section 12a via a second horizontal joint 11a. A second end of the second arm section 12a is connected to the first hand 14a via a third horizontal joint 13a.
A supporting column 15 including a supporting member 16 is attached to the supporting base 8. A first end of a first arm section 10b is connected to the supporting column 15 via a first horizontal joint 9b that is disposed on the supporting base 8 and that includes a drive mechanism (not shown). A second end of the first arm section 10b is connected to a first end of a second arm section 12b via a second horizontal joint 11b. A second end of the second arm section 12b is connected to the first hand 14b via a third horizontal joint 13b. The first arm sections 10a and 10b and the second arm sections 12a and 12b face each other and form a facing structure. In the present embodiment, the first horizontal joints 9a and 9b are coaxially disposed so as to face each other in the vertical direction. However, even if the first horizontal joints 9a and 9b are disposed offset from each other with respect to the direction in which the hands 14a and 14b are moved, movement the same as that of the present embodiment can be performed by changing the lengths of the first arm sections 10a and 10b and the second arm sections 12a and 12b. The first horizontal joints 9a and 9b and the third horizontal joints 13a and 13b are disposed on a line with respect to the direction in which the hands 14a and 14b are moved. When the hands 14a and 14b vertically overlap each other, the first horizontal joints 9a and 9b and the third horizontal joints 13a and 13b are disposed vertically coaxial with each other.
In the present embodiment, the rotation axes of the first horizontal joints 9a and 9b are forwardly offset from the rotation axis of the rotation mechanism 17 with respect to the direction in which the hands are moved, so that interference with the rotation mechanism 17 can be avoided. However, even if the rotation axes of the first horizontal joints 9a and 9b are offset in any of forward, backward, left, and right directions with respect to the direction in which the hands 14a and 14b are moved, movement the same as that of the present embodiment can be performed by changing the lengths of the first arm sections 10a and 10b and the second arm sections 12a and 12b.

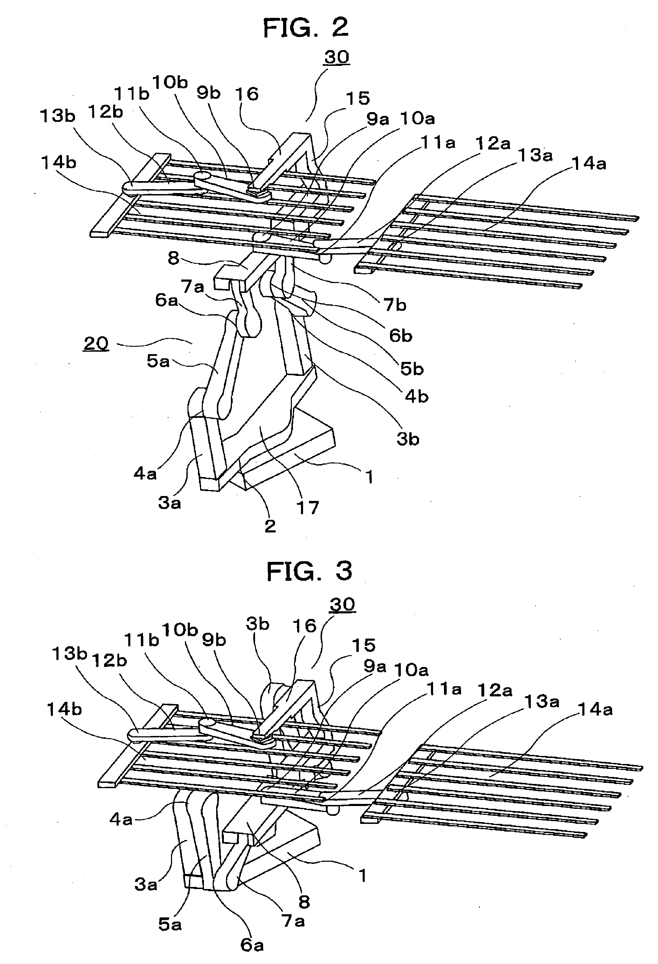

Next, movement will be described. First, referring to Figs. 2 and 3, movement of the lift mechanism will be described. Fig. 2 illustrates a state in which the lift mechanism 20 is at the highest position. Fig. 3 illustrates a state in which the lift mechanism 20 is at the lowest position. One part of the lift mechanism will be described, and description of the other part will be omitted because the other part is plane-symmetric therewith.
Referring to Figs. 1 and 2, a case in which the lift mechanism is moved to the highest position will be described. Drive mechanisms (not shown), which include motors and the like, of the first joint 4a and the second joint 6a are driven. The first leg section 5a rotates counterclockwise around the first joint 4a, viewed from the direction in which the hand 14a is moved. The second leg section 7a rotates clockwise around the second joint 6a. Thus, the horizontal arm mechanism 30 is moved to the highest position.
Referring to Figs. 1 and 3, a case in which the lift mechanism is moved to the lowest position will be described. Drive mechanisms (not shown), which include motors and the like, of the first joint 4a and the second joint 6a are driven. The first leg section 5a rotates clockwise around the first joint 4a, viewed from the direction in which the hand 14a is moved. The second leg section 7a rotates counterclockwise around the second joint 6a. Thus, the horizontal arm mechanism 30 is lowered. When the first leg section 5a is at a height equal to the height of a surface of the base 2, the first leg section 5a further rotates clockwise around the first joint 4a to such an extent that a lateral side of the first leg section 5a does not considerably protrude from a lateral side of the leg supporting member 3a. The second leg section 7a rotates clockwise around the second joint 6a to the highest position.
When the horizontal arm mechanism 30 has been moved to the lowest position, the horizontal arm mechanism 30 is disposed between parts of the lift mechanism 20. Thus, a workpiece disposed at the lowest position of the cabinet (not shown) can be taken out with the hand 14a attached to the supporting base 8.
Even if one part of the lift mechanism 20 breaks down, the other part of the lift mechanism 20 can drive the horizontal arm mechanism. Therefore, the horizontal arm mechanism is prevented from falling and can be safely moved to the lowest position, so that a workpiece is prevented from being damaged.
The diameter of the rotation area is equal to the distance from the axis of the rotation mechanism 17 to lateral sides of the leg supporting members 3a and 3b. Thus, a comparatively small installation space can be realized.

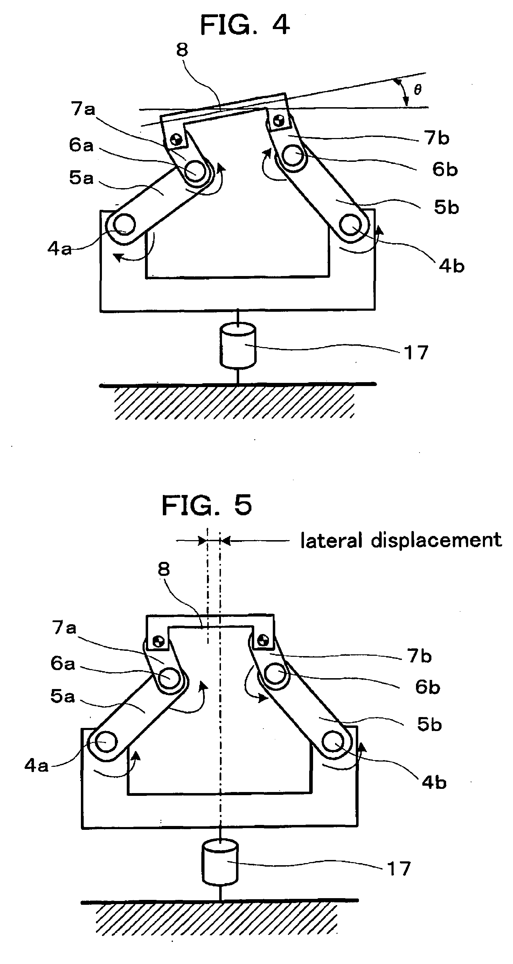

Next, referring to Fig. 4, correction movement performed by the lift mechanism when the cabinet is disposed at an angle in a roll direction with respect to the direction in which the hand is moved will be described.
Directions of inclination will be described below. The roll direction is the direction of rotation around an axis extending in the direction in which the hand is moved. A yaw direction (described below) is the direction of rotation around an axis along which the lift mechanism vertically moves up and down.
Fig. 4 is a schematic view of the lift mechanism viewed from the direction in which a workpiece is transferred to the cabinet.
When the cabinet is disposed at an angle θ, the first joint 4a is rotated clockwise so as to rotate the first leg section 5a by the angle θ from a horizontal state, and the second joint 6a is rotated counterclockwise so as to rotate the second leg section 7a by the angle θ from a horizontal state. The first joint 4b is rotated counterclockwise so as to rotate the first leg section 5b by the angle θ from a horizontal state, and the second joint 6b is rotated clockwise so as to rotate the second leg section 7b by the angle θ from a horizontal state. Thus, the supporting base 8 is held in a state inclined at the angle θ relative to a horizontal state. A horizontal arm mechanism (not shown) disposed on the supporting base 8 is held in a state inclined at the angle θ relative to a horizontal state.
In order to correct such an inclination, for example, an operator manually corrects the inclination using a teach pendant when the operator teaches the transfer robot the movement for taking out a workpiece from the cabinet and transferring the workpiece. Once the movement has been taught, the transfer robot moves on substantially the same trajectory when transferring a workpiece.

Next, correction movement that is performed when the cabinet is disposed at an angle in the yaw direction with respect to the direction in which the hand is moved will be described. In order to correct such an inclination, for example, an operator manually corrects the inclination using a teach pendant when the user teaches the transfer robot movement for taking out a workpiece from the cabinet and transferring the workpiece. At this time, correction movement is made around an axis to a predetermined angle by the rotation mechanism 17 illustrated in Fig. 4. Once the movement has been taught, the transfer robot moves on substantially the same trajectory when transferring a workpiece.

Next, referring to Fig. 5, correction movement performed when the cabinet is disposed in a laterally displaced position with respect to the direction in which the hand is moved will be described. Fig. 5 is a schematic view of the lift mechanism viewed from the direction in which a workpiece is transferred to the cabinet.
When the cabinet is disposed with a lateral displacement, the first joint 4a is rotated counterclockwise so as to rotate the first leg section 5a by an angle θ from a horizontal state, and the second joint 6a is rotated clockwise so as to rotate the second leg section 7a by the angle θ from a horizontal state. The first joint 4b is rotated clockwise so as to rotate the first leg section 5b by the angle θ from a horizontal state, and the second joint 6b is rotated clockwise so as to rotate the second leg section 7b by the angle θ from a horizontal state. Thus, the supporting base 8 can be moved laterally while maintaining a horizontal state, and a horizontal arm mechanism (not shown) disposed on the supporting base 8 can be moved laterally while maintaining a horizontal state.

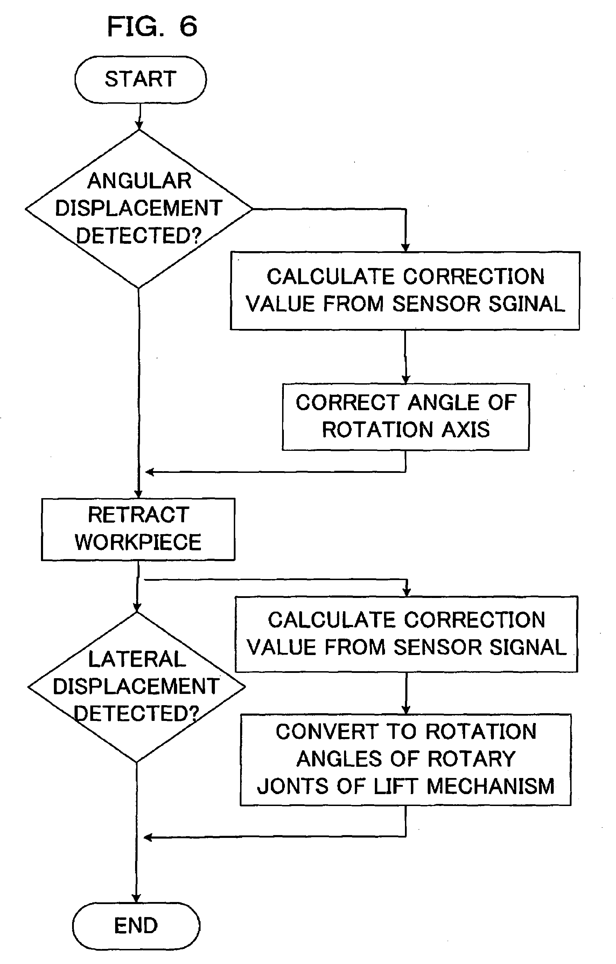

The cases in which the cabinet is disposed at an angle or disposed with a lateral displacement have been described. However, it is possible that a workpiece is disposed at an angle or with a lateral displacement in the cabinet. Regarding the inclination of the workpiece, it is necessary to consider an inclination in the yaw direction, and it is not necessary to consider an inclination in the roll direction with respect to the direction in which the workpiece is transferred. This is because an inclination of the workpiece in the roll direction, which may be caused by an inclination of a surface of the cabinet on which the workpiece is disposed, does not usually occur because the interior of the cabinet is manufactured with high precision. Referring to the flowchart of Fig. 6, correction of an inclination in the yaw direction and a lateral displacement will be described.
(1) A workpiece is placed on a hand of the robot.
(2) An angular displacement is detected from a relative angle of two sensors (not shown) disposed on the hand.
(3) The angular displacement detected in step 2 is corrected by being converted to a rotation angle of the rotation mechanism.
(4) When a glass substrate placed on the hand of the robot has been retracted, lateral displacement is detected with distance detection sensors (not shown) disposed on the supporting base and the supporting member.
(5) If there is lateral displacement, the position is corrected by converting the amount of the lateral displacement to rotation angles of the joints.
(6) The robot is moved to a work area while maintaining the position in which the angle and the position have been corrected.
   With these steps, displacement in the yaw direction and in the lateral direction of a workpiece placed on the hand can be corrected.
   The sensors for detecting angular displacement are disposed on members of the hands 14a and 14b to which the third horizontal joint 13a is attached as illustrated in Fig. 1. Reflective proximity sensors or the like can be used as these sensors. The distance detection sensors for detecting lateral displacement, which are transmission sensors, are disposed on an upper surface of the supporting base 8, to which the first arm section 10a is attached, and on the lower surface of the supporting member 16, to which the first arm section 10b is attached, so as to face each other. The distance detection sensors are disposed at positions in the vicinity of the supporting column 15 through which a side of a workpiece passes.
   Even if the sensors for detecting angular displacement are not provided to the hand, inclination of a workpiece in the yaw direction can be detected if the detected values of the transmission sensors vary when the hand is retracted to a space between the supporting base and the supporting member. The inclination in the yaw direction can be calculated from the difference in the detected values. The inclination that has been calculated can be corrected by converting the inclination to a rotation angle around the rotation axis.

Next, referring to Fig. 1, movement of the horizontal arm mechanism 30 will be described. First ends of the first arm sections 10a and 10b are respectively connected to the supporting base 8 and the supporting member 16. Second ends of the first arm sections 10a and 10b are respectively connected to first ends of the second arm sections 12a and 12b via the second horizontal joints 11a and 11b. Second ends of the second arm sections 12a and 12b are respectively connected to the first hands 14a and 14b via the third horizontal joints 13a and 13b. When rotation drive mechanisms included in the supporting base 8 and the supporting member 16 are driven, the driving force is transmitted to the horizontal joints through, for example, a belt drive, and the hands 14a and 14b are moved in one direction. The hand 14a is illustrated to be at a position at which the arms are extended, and the hand 14b is illustrated to be at a position at which the arms are contracted. In the present embodiment, in the upper and lower parts of the horizontal arm mechanism 30, the second horizontal joints 11a and 11b are extended toward opposite directions. However, this is not a limitation, and, for example, the second horizontal joints 11a and 11b may be moved in a horizontal direction opposite the supporting column 15.
In the present invention, a horizontal arm mechanism having upper and lower arms has been described. However, it is self-evident that the present invention can be applied to a horizontal arm mechanism having an upper arm or a lower arm.

### Industrial Applicability

In the present invention, a robot for transferring liquid-crystal substrate and semiconductor wafers has been described. However, substrates similar to these, such as substrates for solar panels and organic electroluminescent displays, can be transferred.

## Claims

1. A transfer robot comprising:
a hand section (14a, 14b) on which an object is placed;
a horizontal arm mechanism (30) connected to the hand section(14a, 14b), said horizontal arm mechanism (30) comprising a second arm section (12a, 12b) rotatably supporting said hand section (14a, 14b)), and a first arm section (10a, 10b) rotatably supporting the second arm section (12a, 12b), the horizontal arm mechanism (30) extending and contracting so as to move the hand section (14a, 14b)) along one direction ; and
a lift mechanism (20) that moves the horizontal arm mechanism (30) up and down,
wherein the lift mechanism (20) includes
a first link mechanism disposed on a first side of a base member (2), the first link mechanism comprising a first-side first leg sections (5a) rotatably supported via a first-side first joint (4a) by a first-side leg supporting member (3a) extending upward from a first end of the base member (2), and a first-side second leg section (7a) that is rotatably supported by the first-side first leg section (5a) via a first-side, second joint (6a), the first-side second leg section (7a) rotatably supporting the horizontal arm mechanism (20), and
a second link mechanism disposed on a second side of the base member (2), the second link mechanism comprising a second-side first leg sections (5b) rotatably supported via a second-side first joint (4b) by a second-side leg supporting member (3b) extending upward from a second end of the base member (2), and a second-side second leg section (7b) that is rotatably supported by the second-side first leg section (5b) via a second-side second joint (6b), the second-side second leg section (7b) rotatably supporting the horizontal arm mechanism,
and wherein the horizontal arm mechanism (30) is moved up and down by rotating said leg sections and is disposed between the leg supporting member (3a, 3b) when the horizontal arm mechanism is at the lowest position,
**characterized in that**
the first-side first joint (4a), the second-side first joint (4b), the first-side second joint (6a) and the second side second joint (6b) are disposed so that the rotation axis of each of them is parallel to the direction in which the hand section moves

2. The transfer robot according to Claim 1, wherein
the first-side first leg section (5a) is rotatably supported on an upper end of the first-side leg supporting member (3a) via the first-side first joint (4a),
and the second-side first leg section (5b) is rotatably supported on an upper end of the second-side leg supporting member (3b) via the second-side first joint (4b) and
wherein the first-side first leg section (5a) is longer than the first-side leg supporting member (3a), and the second-side first leg section (5b) is longer than the second-side leg supporting member (3b).

3. The transfer robot according to Claim 1,
wherein, the first-side second leg section (7a) is rotatably supported on an end of the first-side first leg section (5a) via the first-side second joint (6a), the first-side first leg section (5a) being longer than the first-side second leg section (7a), and
wherein the second-side second leg section (7b) is rotatably supported on an end of the second-side first leg section (5b) via the second-side second joint (6b), the second-side first leg section (5b) being longer than the second-side second leg section (7b).

4. The transfer robot according to Claim 1,
Wherein the first-side first joint (4a) and the second-side first joint (4b) include drive mechanisms that respectively drive the first-side first leg section (5a) and the second-side first leg section (5b), and
Wherein the first-side second joint (6a) and the second-side second joint (6b) include drive mechanisms that respectively drive the first-side second leg section (7a) and the second-side second leg section (7b).

5. The transfer robot according to Claim 1,
Wherein it comprises a rotation mechanism (17) that rotates the base member (2) around a rotation axis disposed at the center of the base member (2)..

6. The transfer robot according to claim 1,
wherein the horizontal arm mechanism (30) includes
a lower-side arm mechanism including a lower-side hand section (14a) on which the object can be placed, a lower-side second arm (12a) that rotatably supports the lower-side hand section (14a) via a lower-side third horizontal joint (13a), and a lower-side first arm (10a) that rotatably supports the lower-side second arm (12a) via a lower-side second horizontal joint (11a),
an upper-side arm mechanism including an upper-side hand section (14b) on which the object can be placed, an upper-side second arm (12b) that rotatably supports the upper-side hand section (14b) via an upper-side third horizontal joint (13b), and an upper-side first arm (10b) that rotatably supports the upper-side second arm (12b) via a lower-side second horizontal joint (11b),
a supporting base (8) that rotatably supports the lower-side first arm (10a) via a lower-side first horizontal joint (9a), the supporting base (8) being supported by the first-side second leg section (7a) and the second-side second leg section (7b),
a supporting member (16) that rotatably supports the upper-side first arm (10b) via an upper-side first horizontal joint (9b), and
a supporting column (15) that supports an end of the supporting member (16), the supporting column (15) standing on an end of the supporting base (8),
wherein the lower-side arm mechanism and the upper-side arm mechanism are disposed so as to face each other in up-down directions between the supporting member (16) and the supporting base (8), and the lower-side arm mechanism and the upper-side arm mechanism move between the supporting member (16) and the supporting base (8).

7. The transfer robot according to Claim 6,
Wherein a rotation axis of the lower-side first horizontal joint (9a) and a rotation axis the upper-side first horizontal joint (9b) are disposed vertically coaxial with each other.

8. The transfer robot according to Claim 6,
wherein a rotation axis of the lower-side first horizontal joint (9a) and a rotation axis the upper-side first horizontal joint (9b) are disposed vertically coaxial with each other and in an offset manner with respect to a direction in which the lower-side hand section and the upper-side hand section are moved.

9. The transfer robot according to Claim 6, further comprising:
a rotation mechanism (17) that rotates the base member (2),
wherein a rotation axis of the lower-side first horizontal joint (9a) and a rotation axis the upper-side first horizontal joint (9b) are disposed vertically coaxial with each other and offset from a rotation axis of the rotation mechanism with respect to a direction in which the lower-side hand section and the upper-side hand section are moved.

10. The transfer robot according to Claim 6,
wherein a lower-side second horizontal joint (11a) of the lower-side arm mechanism and the upper-side second horizontal joint (11b) of the upper-side arm mechanism are moved toward different sides with respect to an axis extending in the direction in which the lower-side hand section (14a) and the upper-side hand section (14b) move.

11. The transfer robot according to Claim 6, further comprising:
a pair of sensors disposed in each of the lower-side hand section (14a) and the upper-side hand section (14b), and
a distance detection sensor disposed in each of the supporting base (8) and the supporting member (16),
Wherein the pair of sensors detect angular displacements of the object placed on the lower-side hand section and the object placed on the upper-side hand section and
wherein the distance detection sensors detect lateral displacements of the object placed on the lower-side hand section and the object placed on the upper-side hand section, the lateral displacements being with respect in which the hand section move.

## Patentansprüche

1. Transferroboter, umfassend:
einen Handabschnitt (14a, 14b), auf den ein Gegenstand gelegt wird;
einen horizontalen Armmechanismus (30), der mit dem Handabschnitt (14a, 14b) verbunden ist, wobei der horizontale Armmechanismus (30) einen zweiten Armabschnitt (12a, 12b), der den Handabschnitt (14a, 14b) drehbar trägt, und
einen ersten Armabschnitt (10a, 10b) umfasst, der den zweiten Armabschnitt (12a, 12b) drehbar trägt, wobei der horizontale Armmechanismus (30) ausfährt und einfährt, um den Handabschnitt (14a, 14b) entlang einer Richtung zu bewegen; und
einen Hebemechanismus (20), der den horizontalen Armmechanismus (30) hinauf und hinunter bewegt,
wobei der Hebemechanismus (20) Folgendes umfasst:
einen ersten Verbindungsmechanismus, der auf einer ersten Seite eines Sockelelements (2) angeordnet ist, wobei der erste Verbindungsmechanismus einen ersten Beinabschnitt (5a) auf einer ersten Seite, der über eine erste Verbindungsstelle (4a) auf einer ersten Seite durch ein Beintragelement (3a) auf einer ersten Seite, das sich von einem ersten Ende des Sockelelements (2) nach oben erstreckt, drehbar getragen wird, und einen zweiten Beinabschnitt (7a) auf einer ersten Seite umfasst, der über eine zweite Verbindungsstelle (6a) auf einer ersten Seite durch den ersten Beinabschnitt (5a) auf der ersten Seite drehbar getragen wird, wobei der zweite Beinabschnitt (7a) auf der ersten Seite den horizontalen Armmechanismus (30) drehbar trägt, und
einen zweiten Verbindungsmechanismus, der auf einer zweiten Seite des Sockelelements (2) angeordnet ist, wobei der zweite Verbindungsmechanismus einen ersten Beinabschnitt (5b) auf einer zweiten Seite, der über eine erste Verbindungsstelle (4b) auf einer zweiten Seite durch ein Beintragelement (3b) auf einer zweiten Seite, das sich von einem zweiten Ende des Sockelelements (2) nach oben erstreckt, drehbar getragen wird, und einen zweiten Beinabschnitt (7b) auf einer zweiten Seite umfasst, der über eine zweite Verbindungsstelle (6b) auf einer zweiten Seite durch den ersten Beinabschnitt (5b) auf der zweiten Seite drehbar getragen wird, wobei der zweite Beinabschnitt (7b) auf der zweiten Seite den horizontalen Armmechanismus drehbar trägt,
und wobei der horizontale Armmechanismus (30) durch Drehen der Beinabschnitte hinauf und hinunter bewegt wird und zwischen den Beintragelementen (3a, 3b) angeordnet ist, wenn der horizontale Armmechanismus sich in der untersten Stellung befindet,
**dadurch gekennzeichnet, dass**
die erste Verbindungsstelle (4a) auf der ersten Seite, die erste Verbindungsstelle (4b) auf der zweiten Seite, die zweite Verbindungsstelle (6a) auf der ersten Seite und die zweite Verbindungsstelle (6b) auf der zweiten Seite derart angeordnet sind, dass die Drehachse von jeder davon parallel zu der Richtung ist, in die sich der Handabschnitt bewegt.

2. Transferroboter nach Anspruch 1, wobei:
der erste Beinabschnitt (5a) auf der ersten Seite über die erste Verbindungsstelle (4a) auf der ersten Seite drehbar auf einem oberen Ende des Beintragelements (3 a) auf der ersten Seite getragen wird,
und der erste Beinabschnitt (5b) auf der zweiten Seite über die erste Verbindungsstelle (4b) auf der zweiten Seite drehbar auf einem oberen Ende des Beintragelements (3b) auf der zweiten Seite getragen wird, und
wobei der erste Beinabschnitt (5a) auf der ersten Seite länger ist als das Beintragelement (3a) auf der ersten Seite, und der erste Beinabschnitt (5b) auf der zweiten Seite länger ist als das Beintragelement (3b) auf der zweiten Seite.

3. Transferroboter nach Anspruch 1,
wobei der zweite Beinabschnitt (7a) auf der ersten Seite über die zweite Verbindungsstelle (6a) auf der ersten Seite drehbar auf einem Ende des ersten Beinabschnitts auf der ersten Seite getragen wird, wobei der erste Beinabschnitt (5a) auf der ersten Seite länger ist als der zweite Beinabschnitt (7a) auf der ersten Seite, und
wobei der zweite Beinabschnitt (7b) auf der zweiten Seite über die zweite Verbindungsstelle (6b) auf der zweiten Seite drehbar auf einem Ende des ersten Beinabschnitts (5b) auf der zweiten Seite getragen wird, wobei der erste Beinabschnitt (5b) auf der zweiten Seite länger ist als der zweite Beinabschnitt (7b) auf der zweiten Seite.

4. Transferroboter nach Anspruch 1,
wobei die erste Verbindungsstelle (4a) auf der ersten Seite und die erste Verbindungsstelle (4b) auf der zweiten Seite Antriebsmechanismen umfassen, die den ersten Beinabschnitt (5a) auf der ersten Seite beziehungsweise den ersten Beinabschnitt (5b) auf der zweiten Seite antreiben, und
wobei die zweite Verbindungsstelle (6a) auf der ersten Seite und die zweite Verbindungsstelle (6b) auf der zweiten Seite Antriebsmechanismen umfassen, die den zweiten Beinabschnitt (7a) auf der ersten Seite beziehungsweise den zweiten Beinabschnitt (7b) auf der zweiten Seite antreiben.

5. Transferroboter nach Anspruch 1,
wobei er einen Drehmechanismus (17) umfasst, der das Sockelelement (2) um eine Drehachse dreht, die in der Mitte des Sockelelements (2) angeordnet ist.

6. Transferroboter nach Anspruch 1,
wobei der horizontale Armmechanismus (30) Folgendes umfasst:
einen Armmechanismus auf einer unteren Seite, der einen Handabschnitt (14a) auf einer unteren Seite, auf den der Gegenstand gelegt werden kann, einen zweiten Arm auf einer unteren Seite (12a), der den Handabschnitt (14a) auf der unteren Seite über eine dritte horizontale Verbindungsstelle (13a) auf einer unteren Seite drehbar trägt, und einen ersten Arm (l0a) auf einer unteren Seite umfasst, der den zweiten Arm (12a) auf der unteren Seite über eine zweite horizontale Verbindungsstelle (11a) auf einer unteren Seite drehbar trägt,
einen Armmechanismus auf einer oberen Seite, der einen Handabschnitt (14b) auf einer oberen Seite, auf den der Gegenstand gelegt werden kann, einen zweiten Arm (12b) auf einer oberen Seite, der den Handabschnitt (14b) auf der oberen Seite über eine dritte horizontale Verbindungsstelle (13b) auf einer oberen Seite drehbar trägt, und einen ersten Arm (10b) auf einer oberen Seite umfasst, der den zweiten Arm (12b) auf der oberen Seite über eine zweite horizontale Verbindungsstelle (11b) auf einer unteren Seite drehbar trägt,
einen Tragsockel (8), der den ersten Arm (10a) auf der unteren Seite über eine erste horizontale Verbindungsstelle (9a) auf einer unteren Seite drehbar trägt,
wobei der Tragsockel (8) durch den zweiten Beinabschnitt (7a) auf der ersten Seite und den zweiten Beinabschnitt (7b) auf der zweiten Seite getragen wird,
ein Tragelement (16), das den ersten Arm (10b) auf der oberen Seite über eine erste horizontale Verbindungsstelle (9b) auf einer oberen Seite drehbar trägt, und eine Tragsäule (15), die ein Ende des Tragelements (16) trägt, wobei die Tragsäule (15) auf einem Ende des Tragsockels (8) steht,
wobei der Armmechanismus auf der unteren Seite und der Armmechanismus auf der oberen Seite derart angeordnet sind, dass sie einander in der Aufwärts- und
der Abwärtsrichtung zwischen dem Tragelement (16) und dem Tragsockel (8) gegenüberstehen, und der Armmechanismus auf der unteren Seite und der Armmechanismus auf der oberen Seite sich zwischen dem Tragelement (16) und
dem Tragsockel (8) bewegen.

7. Transferroboter nach Anspruch 6,
wobei eine Drehachse der ersten horizontalen Verbindungsstelle (9a) auf der unteren Seite und eine Drehachse der ersten horizontalen Verbindungsstelle (9b) auf der oberen Seite vertikal koaxial zueinander angeordnet sind.

8. Transferroboter nach Anspruch 6,
wobei eine Drehachse der ersten horizontalen Verbindungsstelle (9a) auf der unteren Seite und eine Drehachse der ersten horizontalen Verbindungsstelle (9b) auf der oberen Seite vertikal koaxial zueinander und auf eine versetzte Weise in Bezug auf eine Richtung angeordnet sind, in die der Handabschnitt auf der unteren Seite und der Handabschnitt auf der oberen Seite bewegt werden.

9. Transferroboter nach Anspruch 6, der überdies Folgendes umfasst:
einen Drehmechanismus (17), der das Sockelelement (2) dreht,
wobei eine Drehachse der ersten horizontalen Verbindungsstelle (9a) auf der unteren Seite und eine Drehachse der ersten horizontalen Verbindungsstelle (9b) auf der oberen Seite vertikal koaxial zueinander und versetzt von einer Drehachse des Drehmechanismus in Bezug auf eine Richtung angeordnet sind,
in die der Handabschnitt auf der unteren Seite und der Handabschnitt auf der oberen Seite bewegt werden.

10. Transferroboter nach Anspruch 6,
wobei eine zweite horizontale Verbindungsstelle (11a) auf einer unteren Seite des Armmechanismus auf der unteren Seite und die zweite horizontale Verbindungsstelle (11b) auf der oberen Seite des Armmechanismus auf der oberen Seite in Bezug auf eine Achse, die sich in die Richtung erstreckt, in die der Handabschnitt (14a) auf der unteren Seite und der Handabschnitt (14b) auf der oberen Seite bewegt werden, in Richtung verschiedener Seiten bewegt werden.

11. Transferroboter nach Anspruch 6, der überdies Folgendes umfasst:
ein Sensorenpaar, die in jedem des Handabschnitts (14a) auf der unteren Seite und des Handabschnitts (14b) auf der oberen Seite angeordnet sind, und
einen Abstandserfassungssensor, der in jedem des Tragsockels (8) und des Tragelements (16) angeordnet ist,
wobei das Paar von Sensoren Winkelverschiebungen des auf den Handabschnitt auf der unteren Seite gelegten Gegenstands und des auf den Handabschnitt auf der oberen Seite gelegten Gegenstands erfasst, und
wobei die Abstandserfassungssensoren seitliche Verschiebungen des auf den Handabschnitt auf der unteren Seite gelegten Gegenstands und des auf den Handabschnitt auf der oberen Seite gelegten Gegenstands erfassen, wobei die seitlichen Verschiebungen in Bezug auf die Bewegung des Handabschnitts erfolgen.

## Revendications

1. Robot de transfert comprenant :
une section de main (14a, 14b) sur laquelle un objet est placé ;
un mécanisme de bras horizontal (30) couplé à la section de main (14a, 14b), ledit mécanisme de bras horizontal (30) comprenant une seconde section de bras (12a, 12b) supportant avec liberté de rotation ladite section de main (14a, 14b), et une première section de bras (10a, 10b) supportant avec liberté de rotation la seconde section de bras (12a, 12b), le mécanisme de bras horizontal (30) s'étendant et se contractant de manière à déplacer la section de main (14a, 14b) suivant une première direction ; et
un mécanisme de levage (20) qui déplace le mécanisme de bras horizontal (30) verticalement,
dans lequel le mécanisme de levage (20) comporte
un premier mécanisme de liaison disposé sur un premier côté d'un élément de base (2), le premier mécanisme de liaison comprenant une première section de jambe du premier côté (5a) supportée avec liberté de rotation par l'intermédiaire d'une première articulation du premier côté (4a) par un élément de support de jambe du premier côté (3a) s'étendant vers le haut à partir d'une première extrémité de l'élément de base (2), et une seconde section de jambe du premier côté (7a) qui est supportée avec liberté de rotation par la première section de jambe du premier côté (5a) par l'intermédiaire d'une seconde articulation du premier côté (6a), la seconde section de jambe du premier côté (7a) supportant avec liberté de rotation le mécanisme de bras horizontal (30), et
un second mécanisme de liaison disposé sur un second côté de l'élément de base (2), le second mécanisme de liaison comprenant une première section de jambe du second côté (5b) supportée avec liberté de rotation par l'intermédiaire d'une première articulation du second côté (4b) par un élément de support de jambe du second côté (3b) s'étendant vers le haut à partir d'une seconde extrémité de l'élément de base (2), et une seconde section de jambe du second côté (7b) qui est supportée avec liberté de rotation par la première section de jambe du second côté (5b) par l'intermédiaire d'une seconde articulation du second côté (6b), la seconde section de jambe du second côté (7b) supportant avec liberté de rotation le mécanisme de bras horizontal,
et dans lequel le mécanisme de bras horizontal (30) est déplacé verticalement par la rotation desdites sections de jambe et est disposé entre les éléments de support de jambe (3a, 3b) lorsque le mécanisme de bras horizontal est à la position la plus basse,
**caractérisé en ce que**
la première articulation du premier côté (4a), la première articulation du second côté (4b), la seconde articulation du premier côté (6a) et la seconde articulation du second côté (6b) sont disposées de telle sorte que l'axe de rotation de chacune d'elle est parallèle à la direction dans laquelle la section de main se déplace.

2. Robot de transfert selon la revendication 1,
dans lequel la première section de jambe du premier côté (5a) est supportée avec liberté de rotation sur une extrémité supérieure de l'élément de support de jambe du premier côté (3a) par l'intermédiaire de la première articulation du premier côté (4a),
et la première section de jambe du second côté (5b) est supportée avec liberté de rotation sur une extrémité supérieure de l'élément de support de jambe du second côté (3b) par l'intermédiaire de la première articulation du second côté (4b) et
dans lequel la première section de jambe du premier côté (5a) est plus longue que l'élément de support de jambe du premier côté (3a), et la première section de jambe du second côté (5b) est plus longue que l'élément de support de jambe du second côté (3b).

3. Robot de transfert selon la revendication 1,
dans lequel, la seconde section de jambe du premier côté (7a) est supportée avec liberté de rotation sur une extrémité de la première section de jambe du premier côté (5a) par l'intermédiaire de la seconde articulation du premier côté (6a), la première section de jambe du premier côté (5a) étant plus longue que la seconde section de jambe du premier côté (7a), et
dans lequel la seconde section de jambe du second côté (7b) est supportée avec liberté de rotation sur une extrémité de la première section de jambe du second côté (5b) par l'intermédiaire de la seconde articulation du second côté (6b), la première section de jambe du second côté (5b) étant plus longue que la seconde section de jambe du second côté (7b).

4. Robot de transfert selon la revendication 1,
dans lequel la première articulation du premier côté (4a) et la première articulation du second côté (4b) comportent des mécanismes d'entraînement qui entraînent respectivement la première section de jambe du premier côté (5a) et la première section de jambe du second côté (5b), et
dans lequel la seconde articulation du premier côté (6a) et le seconde articulation du second côté (6b) comportent des mécanismes d'entraînement qui entraînent respectivement la seconde section de jambe du premier côté (7a) et la seconde section de jambe du second côté (7b).

5. Robot de transfert selon la revendication 1,
dans lequel est compris un mécanisme de rotation (17) qui fait tourner l'élément de base (2) autour d'un axe de rotation disposé au centre de l'élément de base (2).

6. Robot de transfert selon la revendication 1,
dans lequel le mécanisme de bras horizontal (30) comporte
un mécanisme de bras du côté inférieur comportant une section de main du côté inférieur (14a) sur laquelle l'objet peut être placé, un second bras du côté inférieur (12a) qui supporte avec liberté de rotation la section de main du côté inférieur (14a) par l'intermédiaire d'une troisième articulation horizontale du côté inférieur (13a), et un premier bras du côté inférieur (10a) qui supporte avec liberté de rotation le second bras du côté inférieur (12a) par l'intermédiaire d'une deuxième articulation horizontale du côté inférieur (11a),
un mécanisme de bras du côté supérieur comportant une section de main du côté supérieur (14b) sur laquelle l'objet peut être placé, un second bras du côté supérieur (12b) qui supporte avec liberté de rotation la section de main du côté supérieur (14b) par l'intermédiaire d'une troisième articulation du côté supérieur (13b), et un premier bras du côté supérieur (10b) qui supporte avec liberté de rotation le second bras du côté supérieur (12b) par l'intermédiaire d'une deuxième articulation horizontale du côté inférieur (11b),
une base de support (8) qui supporte avec liberté de rotation le premier bras du côté inférieur (10a) par l'intermédiaire d'une première articulation horizontale du côté inférieur (9a), la base de support (8) étant supportée par la seconde section de jambe du premier côté (7a) et la seconde section de jambe du second côté (7b),
un élément de support (16) qui supporte avec liberté de rotation le premier bras du côté supérieur (10b) par l'intermédiaire d'une première articulation horizontale du côté supérieur (9b), et
une colonne de support (15) qui supporte une extrémité de l'élément de support (16), la colonne de support (15) étant dressée sur une extrémité de la base de support (8),
dans lequel le mécanisme de bras du côté inférieur et le mécanisme de bras du côté supérieur sont disposés de manière à être l'un face à l'autre dans la direction verticale entre l'élément de support (16) et la base de support (8), et le mécanisme de bras du côté inférieur et le mécanisme de bras du côté supérieur se déplacent entre l'élément de support (16) et la base de support (8).

7. Robot de transfert selon la revendication 6,
dans lequel un axe de rotation de la première articulation horizontale du côté inférieur (9a) et un axe de rotation de la première articulation horizontale du côté supérieur (9b) sont disposés verticalement, coaxialement l'un par rapport à l'autre.

8. Robot de transfert selon la revendication 6,
dans lequel un axe de rotation de la première articulation horizontale du côté inférieur (9a) et un axe de rotation de la première articulation horizontale du côté supérieur (9b) sont disposés verticalement, coaxialement l'un par rapport à l'autre et d'une manière décalée par rapport à une direction dans laquelle la section de main du côté inférieur et la section de main du côté supérieur sont déplacées.

9. Robot de transfert selon la revendication 6, comprenant en outre :
un mécanisme de rotation (17) qui fait tourner l'élément de base (2),
dans lequel un axe de rotation de la première articulation horizontale du côté inférieur (9a) et un axe de rotation de la première articulation horizontale du côté supérieur (9b) sont disposés verticalement, coaxialement l'un par rapport à l'autre et décalés à partir d'un axe de rotation du mécanisme de rotation par rapport à une direction dans laquelle la section de main du côté inférieur et la section de main du côté supérieur sont déplacées.

10. Robot de transfert selon la revendication 6,
dans lequel une deuxième articulation horizontale du côté inférieur (11a) du mécanisme de bras du côté inférieur et la deuxième articulation horizontale du côté supérieur (11b) du mécanisme de bras du côté supérieur sont déplacées vers différents côtés par rapport à un axe s'étendant dans la direction dans laquelle la section de main du côté inférieur (14a) et la section de main du côté supérieur (14b) se déplacent.

11. Robot de transfert selon la revendication 6, comprenant en outre :
une paire de capteurs disposés dans chacune de la section de main du côté inférieur (14a) et de la section de main du côté supérieur (14b), et
un capteur de détection de distance disposé dans chacun de la base de support (8) et de l'élément de support (16),
dans lequel la paire de capteurs détecte des déplacements angulaires de l'objet placé sur la section de main du côté inférieur et de l'objet placé sur la section de main du côté supérieur et
dans lequel les capteurs de détection de distance détectent des déplacements latéraux de l'objet placé sur la section de main du côté inférieur et de l'objet placé sur la section de main du côté supérieur, les déplacements latéraux étant relatifs aux déplacements de la section de main.
